# EUROPÄISCHE PATENTSCHRIFT

(11) **EP 1 786 034 B1**
(45) Veröffentlichungstag und Bekanntmachung des Hinweises auf die Patenterteilung: **02.02.2011**
(21) Anmeldenummer: 06023025.7
(22) Anmeldetag: 06.11.2006
(51) Int. Cl.: H01L 23/495, H01L 23/538, H01L 21/60, H01L 23/482

(54) **Leistungshalbleitermodul**
Power semiconductor module
Module semi-conducteur de puissance

(30) Priorität: 09.11.2005 DE 102005053398
(43) Veröffentlichungstag der Anmeldung: 16.05.2007
(73) Patentinhaber: Semikron Elektronik GmbH & Co. KG Patentabteilung, 90431 Nürnberg (DE)
(72) Erfinder: Göbl, Christian, 90441 Nürnberg (DE); Augustin, Karlheinz, 90768 Fürth (DE)

(56) Entgegenhaltungen:
- EP-A- 0 649 171
- EP-A- 1 548 829
- WO-A-03/067940
- US-A- 3 361 869
- US-A- 5 633 069

## Beschreibung

Die Erfindung betrifft ein Leistungshalbleitermodul mit einem Substrat, einer Verbundfolie und mindestens einem Leistungshalbleiterbauelement zwischen dem Substrat und der Verbundfolie, die eine schaltstrukturierte Logikmetallschicht und eine im Vergleich hierzu dicke schaltstrukturierte Leistungsmetallschicht sowie zwischen diesen eine dünne elektrisch isolierende Kunststofffolie aufweist, wobei die Verbundfolie mit Kontaktnoppen zur Kontaktierung mit dem mindestens einem Halbleiterbauelement ausgebildet ist, und zwischen der Logikmetallschicht und der Leistungsmetallschicht Durchkontaktierungen vorgesehen sind.

Ein derartiges Leistungshalbleitermodul ist aus der DE 103 55 925 A1 der Anmelderin bekannt. Bei diesem bekannten Leistungshalbleitermodul sind die Durchkontaktierungen durch Laserbohren und anschließendes Laser gestütztes Verfüllen mit einem leitfähigen Werkstoff hergestellt. Damit sind Durchkontaktierungen mit einem Durchmesser von einigen 100 µm möglich. Die Herstellung solcher Durchkontaktierungen ist mit einem nicht zu vernachlässigenden Aufwand verbunden. Außerdem ist beim Verfüllen mit leitfähigem Werkstoff darauf zu achten, dass der Verfüll-Werkstoff mit seinen Werkstoffeigenschaften, wie seinem Wärmeausdehnungskoeffizient, an die Materialien der Verbundfolie angepasst ist.

In Kenntnis dieser Gegebenheiten liegt der Erfindung die Aufgabe zugrunde, ein Leistungshalbleitermodul der eingangs genannten Art zu schaffen, das einfach und preisgünstig realisierbar ist und bei dem die Durchkontaktierungen einfach und zuverlässig realisierbar sind.

Diese Aufgabe wird bei einem Leistungshalbleitermodul der eingangs genannten Art erfindungsgemäß dadurch gelöst, dass die Kunststofffolienlage im Bereich der jeweiligen Durchkontaktierung an einem von der Logikmetallschicht freien Bereich mit einer Aussparung ausgebildet ist, und dass ein flexibles Stück eines Dünndrahtes sich durch den von der Logikmetallschicht freien Bereich und durch die Aussparung in der Kunststofffolie erstreckt und mit der Logikmetallschicht und mit der Leistungsmetallschicht durch Bonden kontaktiert ist.

Bei dem erfindungsgemäßen Leistungshalbleitermodul ist es bevorzugt, wenn die Schaltungsstrukturen der Logikmetallschicht und die Schaltungsstrukturen der Leistungsmetallschicht in einem Arbeitsgang, das heißt gleichzeitig durch Ätzen hergestellt werden. Dieser Ätzvorgang wird in an sich bekannter Weise durchgeführt. Hierbei handelt es sich zweckmäßigerweise um ein Maskenätzen der Verbundfolie, das in vorteilhafterweise quasi endlos kontinuierlich durchführbar ist.

Die Logikmetallschicht des erfindungsgemäßen Halbleitermoduls ist vorzugsweise eine Kupferschicht und seine Leistungsmetallschicht ist vorzugsweise eine Aluminiumschicht. Die Kunststofffolie zwischen der Logikmetallschicht und der Leistungsmetallschicht besteht vorzugsweise aus Polyimid.

Bei der Verbundfolie des erfindungsgemäßen Halbleitermoduls sind die Logikmetallschicht und die Leistungsmetallschicht mit der Kunststofffolie vorzugsweise flächig verklebt.

Die jeweilige Aussparung in der Kunststofffolie der Verbundfolie des erfindungsgemäßen Leistungshalbleitermoduls wird vorzugsweise durch Lasern hergestellt. Zu diesem Zwecke kann zum Beispiel ein CO₂-Beschriftungslaser zur Anwendung gelangen.

Der Dünndraht der jeweiligen Durchkontaktierung besteht vorzugsweise aus Aluminium, er kann beispielsweise einen Durchmesser von 75 µm aufweisen. Die Bondverbindung des Dünndrahtes mit der schaltstrukturierten dünnen Logikmetallschicht und mit der schaltstrukturierten dickeren Leistungsmetallschicht wird zweckmäßigerweise mit einem Standard-Dünndraht-Bonder ausgeführt.

Das erfindungsgemäße Leistungshalbleitermodul weist den Vorteil auf, dass die jeweilige Durchkontaktierung sehr flexibel und zuverlässig ist, wobei der Dünndraht zum Verbinden der Logikmetallschicht und der Leistungsmetallschicht eine Flexibilität besitzt, die die Flexibilität der Logikmetallschicht und der Leistungsmetallschicht berücksichtigt.

Die jeweilige Durchkontaktierung kann nach dem Bonden des Dünndrahtes an der Logikmetallschicht und der Leistungsmetallschicht verprägt und im Bedarfsfall mit einem geeigneten Isoliermaterial abgedeckt werden.

Weitere Einzelheiten, Merkmale und Vorteile ergeben sich aus der nachfolgenden Beschreibung eines in der Zeichnung schematisch und nicht maßstabgetreu gezeichneten Ausführungsbeispieles des erfindungsgemäßen Leistungshalbleitermoduls.

Es zeigen:
- Fig. 1: abschnittweise in einer Schnittdarstellung vergrößert und nicht maßstabgetreu eine Ausbildung des Leistungshalbleitermoduls, und
- Fig. 2: eine weiter vergrößerte Darstellung des Details II in Fig. 1.

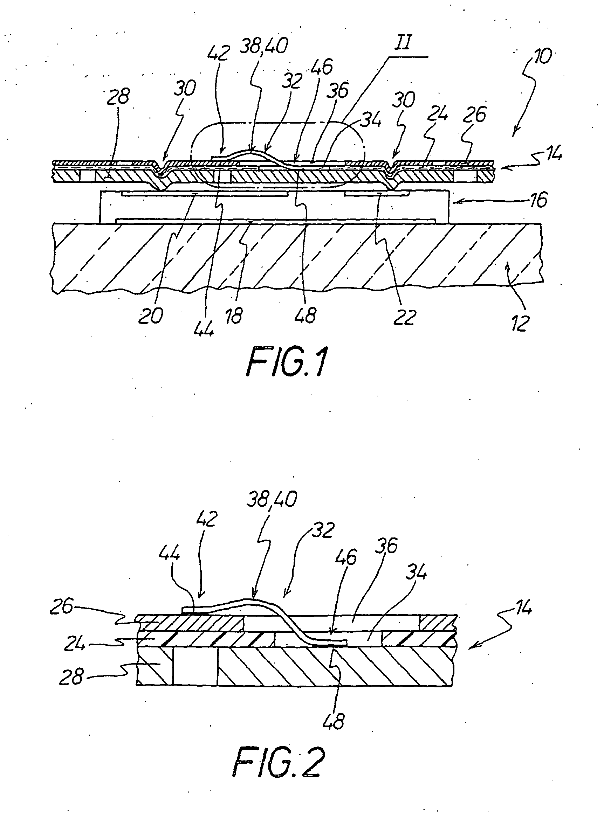

Fig. 1 zeigt abschnittweise geschnitten eine Ausbildung des Leistungshalbleitermoduls 10 mit einem Substrat 12, einer Verbundfolie 14 und einem Leistungshalbleiterbauelement 16, das zwischen dem Substrat 12 und der Verbundfolie 14 vorgesehen ist. Das Leistungshalbleiterbauelement 16 besitzt einen Kollektor 18, einen Emitter 20 und ein Gate 22.

Die Verbundfolie weist eine dünne elektrisch isolierende Kunststofffolie 24 auf, die Kunststofffolie 24 ist auf ihrer einen Hauptfläche mit einer dünnen schaltstrukturierten Logikmetallschicht 26 und auf ihrer davon abgewandten Hauptfläche mit einer schaltstrukturierten Leistungsmetallschicht 28 versehen.

Die Verbundfolie 14 ist mit Noppen 30 ausgebildet, die zur Kontaktierung mit dem Leistungshalbleiterbauelement 16 dienen.

Zwischen der schaltstrukturierten dünnen Logikmetallschicht 26 und der schaltstrukturierten Leistungsmetallschicht 28 sind Durchkontaktierungen 32 vorgesehen, von welchen in Fig. 1 nur eine Durchkontaktierung 32 dargestellt ist, die in Fig. 2 in einem weiter vergrößerten Maßstab, aber nicht maßstabgetreu, gezeichnet ist. Wie aus Fig. 2 deutlich ersichtlich ist, ist die elektrisch isolierende Kunststofffolie 24 im Bereich der jeweiligen Durchkontaktierung 32 mit einer Aussparung 34 ausgebildet. Die Aussparung 34 ist in dem von der Logikmetallschicht 26 durch deren Strukturierung freien Bereich 36, das heißt unter diesem ausgebildet.

Ein flexibles Stück 38 eines Dünndrahtes 40 ist mit seinem Endabschnitt 42 an der schaltstrukturierten Logikmetallschicht 26 festgebondet. Das ist durch die Bezugsziffer 44 angedeutet. Der davon entfernte zweite Endabschnitt 46 des Dünndrahtes 40 ist an der schaltstrukturierten Leistungsmetallschicht 28, festgebondet. Diese Bondstelle ist mit der Bezugsziffer 48 bezeichnet.

Gleiche Einzelheiten sind in den Fig. 1 und 2 jeweils mit denselben Bezugsziffern bezeichnet, so dass es sich erübrigt, in Verbindung mit den Fig. 1 und 2 alle Einzelheiten jeweils detailliert zu beschreiben.

### Bezugsziffernliste:

- 10: Leistungshalbleitermodul
- 12: Substrat (von 10)
- 14: Verbundfolie (von 10 für 16)
- 16: Leistungshalbleiterbauelement (von 10 zwischen 12 und 14)
- 18: Kollektor (von 16)
- 20: Emitter (von 16)
- 22: Gate (von 16)
- 24: elektrisch isolierende Kunststofffolie (von 14)
- 26: schaltstrukturierte Logikmetallschicht (an 24)
- 28: schaltstrukturierte Leistungsmetallschicht (an 24)
- 30: Noppen (von 14 für 16)
- 32: Durchkontaktierungen (zwischen 26 und 28)
- 34: Aussparung (in 24 für 40)
- 36: freier Bereich (von 26 für 40)
- 38: flexibles Stück (von 40)
- 40: Dünndraht (zwischen 26 und 28)
- 42: erster Endabschnitt (von 40)
- 44: Bondstelle (bei 42 zwischen 40 und 26)
- 46: zweiter Endabschnitt (von 40)
- 48: Bondstelle (bei 46 zwischen 40 und 28)

## Patentansprüche

1. Leistungshalbleitermodul mit einem Substrat (12), einer Verbundfolie (14) und mindestens einem Leistungshalbleiterbauelement (16) zwischen dem Substrat (12) und der Verbundfolie (14), die eine dünne schaltstrukturierte Logikmetallschicht (26) und eine im Vergleich hierzu dicke schaltstrukturierte Leistungsmetallschicht (28) sowie zwischen diesen eine dünne elektrisch isolierende Kunststofffolie (24) aufweist, wobei die Verbundfolie (14) mit Kontaktnoppen (30) zur Kontaktierung mit dem mindestens einen Leistungshalbleiterbauelement (16) ausgebildet ist, und zwischen der Logikmetallschicht (26) und der Leistungsmetallschicht (28) Durchkontaktierungen (32) vorgesehen sind,
**dadurch gekennzeichnet,**
**dass** die Kunststofffolie (24) im Bereich der jeweiligen Durchkontaktierung (32) an einem von der Logikmetallschicht (26) freien Bereich (36) mit einer Aussparung (34) ausgebildet ist, und dass ein flexibles Stück (38) eines Dünndrahtes (40) sich durch den von der Logikmetallschicht (26) freien Bereich (36) und durch die Aussparung (34) in der Kunststofffolie (24) erstreckt und mit der Logikmetallschicht (26) und mit der Leistungsmetallschicht (28) durch Bondstellen (44, 48) kontaktiert ist.

2. Leistungshalbleitermodul nach Anspruch 1,
**dadurch gekennzeichnet,**
**dass** die Schaltungsstrukturen der Logikmetallschicht (26) und der Leistungsmetallschicht (28) gleichzeitig durch Ätzen herstellbar sind.

3. Leistungshalbleitermodul nach Anspruch 1,
**dadurch gekennzeichnet,**
**dass** die Logikmetallschicht (26) eine Kupferschicht und die Leistungsmetallschicht (28) eine Aluminiumschicht ist.

4. Leistungshalbleitermodul nach Anspruch 1,
**dadurch gekennzeichnet,**
**dass** die Kunststofffolie (24) aus Polyimid besteht.

5. Leistungshalbleitermodul nach einem der Ansprüche 1 bis 4,
**dadurch gekennzeichnet,**
**dass** die Logikmetallschicht (26) und die Leistungsmetallschicht (28) mit der Kunststofffolie (24) flächig verklebt sind.

6. Leistungshalbleitermodul nach Anspruch 1,
**dadurch gekennzeichnet,**
**dass** die jeweilige Aussparung (34) in der Kunststofffolie (24) durch Lasern herstellbar ist.

7. Leistungshalbleitermodul nach Anspruch 1,
**dadurch gekennzeichnet,**
**dass** der Dünndraht (40) aus Aluminium besteht.

8. Leistungshalbleitermodul nach Anspruch 1,
**dadurch gekennzeichnet,**
**dass** der Dünndraht (40) einen Durchmesser von 75 µm aufweist.

9. Leistungshalbleitermodul nach einem der Ansprüche 1 bis 8,
**dadurch gekennzeichnet,**
**dass** die Durchkontaktierung (32) mit einem Isoliermaterial abgedeckt ist.

## Claims

1. A power semiconductor module with a substrate (12), a composite film (14) and at least one power semiconductor element (16) between the substrate (12) and the composite film (14), which has a structured logic circuit metal layer (26) and a structured circuit power metal layer (28) that is thick in comparison to the former, and between these a thin electrically insulating plastic film (24), wherein
the composite film (14) is designed with contact protuberances (30) for purposes of making contact with the at least one semiconductor element (16), and through-contacts (32) are provided between the logic metal layer (26) and the power metal layer (28),
**characterised in that** the plastic film (24) in the region of the relevant through-contact (32) is designed in a region (36) with a cavity (34) that is free from the logic metal layer (26), and **in that** a flexible length (38) of a thin wire (40) extends through the region (36) free from the logic metal layer (26) and through the cavity (34) in the plastic film (24), and **in that** contact is made with the logic metal layer (26) and with the power metal layer (28) by means of bonding locations (44, 48).

2. The power semiconductor module in accordance with Claim 1,
**characterised in that** the circuit structures of the logic metal layer (26) and the power metal layer (28), can be manufactured simultaneously by means of etching.

3. The power semiconductor module in accordance with Claim 1,
**characterised in that** the logic metal layer (26) is a copper layer, and the power metal layer (28) is an aluminium layer.

4. The power semiconductor module in accordance with Claim 1,
**characterised in that** the plastic film (24) consists of polyimide.

5. The power semiconductor module in accordance with one of the Claims 1 to 4,
**characterised in that** the logic metal layer (26) and the power metal layer (28) are cemented with the plastic film (24) in a planar manner.

6. The power semiconductor module in accordance with Claim 1,
**characterised in that** the relevant cavity (34) in the plastic film (24) can be manufactured by means of lasers.

7. The power semiconductor module in accordance with Claim 1,
**characterised in that** the thin wire (40) consists of aluminium.

8. The power semiconductor module in accordance with Claim 1,
**characterised in that** the thin wire (40) has a diameter of 75 µm.

9. The power semiconductor module in accordance with one of the Claims 1 to 8,
**characterised in that** the through-contact (32) is covered with an insulating material.

## Revendications

1. Module à semi-conducteurs de puissance comprenant un substrat (12), un film composite (14) et au moins un composant à semi-conducteurs de puissance (16) entre le substrat (12) et le film composite (14), qui présente une couche métallique de logique (26) mince et structurée pour la commutation et une couche métallique de puissance (28), structurée pour la commutation et épaisse par rapport à la première et entre celles-ci un film de matière plastique (24) mince et électroconducteur, le film composite (14) étant conçu avec des nopes de contact (30) pour la mise en contact avec le au moins un composant à semi-conducteurs de puissance (16), et des connexions transversales (32) étant prévues entre la couche métallique de logique (26) et la couche métallique de puissance (28),
**caractérisé en ce que**
le film de matière plastique (24) est conçu avec un évidement (34) dans la zone de la connexion transversale (32) respective sur une zone (36) dépourvue de la couche métallique de logique (26), et **en ce qu'**un bout (38) flexible d'un fil mince (40) s'étend à travers la zone (36) dépourvue de la couche métallique de logique (26) et à travers l'évidement (34) dans le film de matière plastique (24) et est mis en contact avec la couche métallique de logique (26) et avec la couche métallique de puissance (28) par des points de liaison (44, 48).

2. Module à semi-conducteurs de puissance selon la revendication 1,
**caractérisé en ce que**
les structures de circuit de la couche métallique de logique (26) et de la couche métallique de puissance (28) peuvent être fabriquées en même temps par décapage.

3. Module à semi-conducteurs de puissance selon la revendication 1,
**caractérisé en ce que**
la couche métallique de logique (26) est une couche de cuivre et la couche métallique de puissance (28) une couche d'aluminium.

4. Module à semi-conducteurs de puissance selon la revendication 1,
**caractérisé en ce que**
le film de matière plastique (24) est à base de polyamide.

5. Module à semi-conducteurs de puissance selon l'une quelconque des revendications 1 à 4,
**caractérisé en ce que**
la couche métallique de logique (26) et la couche métallique de puissance (28) sont collées en surface avec le film de matière plastique (24).

6. Module à semi-conducteurs de puissance selon la revendication 1,
**caractérisé en ce que**
l'évidement (34) respectif dans le film de matière plastique (24) peut être fabriqué par des lasers.

7. Module à semi-conducteurs de puissance selon la revendication 1,
**caractérisé en ce que**
le fil mince (40) est en aluminium.

8. Module à semi-conducteurs de puissance selon la revendication 1,
**caractérisé en ce que**
le film mince (40) présente un diamètre de 75 µm.

9. Module à semi-conducteurs de puissance selon l'une quelconque des revendications 1 à 8,
**caractérisé en ce que**
la connexion transversale (32) est couverte avec un matériau isolant.
